# EUROPEAN PATENT APPLICATION

(11) **EP 4 753 404 A1**
(43) Date of publication of application: **03.06.2026**
(21) Application number: 24860485.2
(22) Date of filing: 02.09.2024
(51) Int. Cl.: H10F 10/19

(54) **TANDEM SOLAR CELL**

(30) Priority: 31.08.2023 KR 20230115409
(71) Applicant: Hanwha Solutions Corporation, Jung-gu Seoul 04541 (KR)
(72) Inventor: LEE, Sun Hwa, Seongnam-si, Gyeonggi-do 13488 (KR); LEE, Hyeong Eun, Seongnam-si, Gyeonggi-do 13488 (KR)
(74) Representative: Mooser, Sebastian Thomas
(86) International application number: PCT/KR2024/013128
(87) International publication number: WO 2025/048569

(57) **Abstract**

An embodiment of the present invention discloses a tandem solar cell including a first photoelectric conversion unit, a second photoelectric conversion unit on the first photoelectric conversion unit, and an intermediate layer positioned between the first photoelectric conversion unit and the second photoelectric conversion unit and electrically connecting the first photoelectric conversion unit to the second photoelectric conversion unit. The first photoelectric conversion unit includes a first photoelectric conversion layer and a first doped layer positioned on a first surface of the first photoelectric conversion layer and between the first photoelectric conversion layer and the intermediate layer. Surface roughness of a second surface is greater than surface roughness of the first surface.

## Description

### Technical Field

The present invention relates to a tandem solar cell.

### Background Art

Crystalline silicon (c-Si) solar cells are representative single-junction solar cells and are currently widely used as commercial solar cells. However, as c-Si solar cells are currently reaching their theoretical efficiency limits, active development is underway on tandem solar cells that may achieve high efficiency. Tandem solar cells have the advantage of being able to increase efficiency by efficiently using incident sunlight by connecting solar cells having different band gaps to each other.

Among these, perovskite/silicon tandem solar cells may achieve a high photoelectric conversion efficiency of at least 30 % and thus attract much attention. Since the band gap of a perovskite is easily controlled, efficient incident light distribution is possible when a perovskite solar cell is joined to a silicon solar cell.

A perovskite solar cell may be formed on a silicon solar cell by a solution process or a deposition process. However, in a case where a lower layer is not flat when a perovskite solar cell is formed, it is difficult for each layer of the perovskite solar cell to be formed uniformly with a certain thickness, and as a result, the photoelectric conversion efficiency of a tandem solar cell may decrease.

### Disclosure of Invention

### Technical Problem

Embodiments of the present invention provide a tandem solar cell having improved photoelectric conversion efficiency.

### Solution to Problem

According to an aspect of the present invention, a tandem solar cell includes a first photoelectric conversion unit, a second photoelectric conversion unit on the first photoelectric conversion unit, and an intermediate layer positioned between the first photoelectric conversion unit and the second photoelectric conversion unit and electrically connecting the first photoelectric conversion unit to the second photoelectric conversion unit, wherein the first photoelectric conversion unit includes a first photoelectric conversion layer and a first doped layer positioned on a first surface of the first photoelectric conversion layer and between the first photoelectric conversion layer and the intermediate layer, and surface roughness of a second surface is greater than surface roughness of the first surface.

### Advantageous Effects of Invention

According to embodiments of the present invention, a defect is prevented from occurring in a first doped layer, and an intermediate layer on a first photoelectric conversion unit and layers forming a second photoelectric conversion unit are uniformly formed, thereby preventing the occurrence of leakage current and improving the photoelectric conversion efficiency and stability of a tandem solar cell.

Since a crystal grain in the first doped layer has a nano size, the first doped layer has a wide optical band gap, and the current matching between the first photoelectric conversion unit and the second photoelectric conversion unit connected in series to each other is optimized, so that the efficiency of the tandem solar cell may be improved.

### Brief Description of Drawings

FIG. 1 is a cross-sectional view schematically illustrating a tandem solar cell according to an embodiment of the present invention.
FIG. 2 is a cross-sectional view schematically illustrating an example of a first photoelectric conversion unit of the tandem solar cell of FIG. 1.
FIGS. 3 and 4 are cross-sectional views each showing the results of forming an intermediate layer according to a first doped layer of the first photoelectric conversion unit of FIG. 2.
FIG. 5 is a cross-sectional view schematically illustrating an example of a second photoelectric conversion unit of the tandem solar cell of FIG. 1.
FIG. 6 is a graph showing current-voltage (I-V) results" results of a tandem solar cell, according to the present invention.

### Best Mode for Carrying out the Invention

According to an aspect of the present invention, a tandem solar cell includes a first photoelectric conversion unit, a second photoelectric conversion unit on the first photoelectric conversion unit, and an intermediate layer positioned between the first photoelectric conversion unit and the second photoelectric conversion unit and electrically connecting the first photoelectric conversion unit to the second photoelectric conversion unit, wherein the first photoelectric conversion unit includes a first photoelectric conversion layer and a first doped layer positioned on a first surface of the first photoelectric conversion layer and between the first photoelectric conversion layer and the intermediate layer, and surface roughness of a second surface is greater than surface roughness of the first surface.

In the present embodiment, the first photoelectric conversion unit may correspond to a silicon solar cell, and crystallinity of the first doped layer may be 30 % to 70 %.

In an embodiment, a thickness of the first doped layer may be 40 nm to 100 nm.

In an embodiment, an optical band gap of the first doped layer may be 1.2 eV to 1.8 eV.

In an embodiment, the second surface may have an uneven structure.

The tandem solar cell may further include a second doped layer positioned on the second surface of the first photoelectric conversion layer, the second surface being opposite to the first surface.

In an embodiment, the tandem solar cell may further include a protective layer covering the second doped layer.

In an embodiment, the second photoelectric conversion unit may include a first charge transport layer, a second charge transport layer, and a second photoelectric conversion layer between the first charge transport layer and the second charge transport layer.

In an embodiment, the second photoelectric conversion layer may include a compound having a perovskite structure.

In an embodiment, the second photoelectric conversion unit may further include a conductive oxide electrode layer on an outer surface thereof.

According to another aspect of the present invention, a tandem solar cell includes a silicon solar cell, a perovskite solar cell on the silicon solar cell, and an intermediate layer positioned between the silicon solar cell and the perovskite solar cell and electrically connecting the silicon solar cell to the perovskite solar cell, wherein the silicon solar cell includes a silicon semiconductor layer and a first doped layer positioned on a first surface of the silicon semiconductor layer and between the silicon semiconductor layer and the intermediate layer, the silicon semiconductor layer and the first doped layer have different crystallinity, and the crystallinity of the first doped layer is 30 % to 70 %.

In an embodiment, the silicon solar cell may further include a second doped layer positioned on a second surface of the silicon semiconductor layer, the second surface being opposite to the first surface, and surface roughness of the second surface may be greater than surface roughness of the first surface.

In an embodiment, the second surface may have an uneven structure.

In an embodiment, a thickness of the first doped layer may be 40 nm to 100 nm.

In an embodiment, an optical band gap of the first doped layer may be 1.2 eV to 1.8 eV.

In an embodiment, the perovskite solar cell may include a first charge transport layer, a second charge transport layer, and a perovskite layer between the first charge transport layer and the second charge transport layer.

### Mode for the Invention

The present invention may undergo various modifications and have various embodiments, and specific embodiments are illustrated in the drawings and described in detail in the detailed description. The effects and features of the present invention and the method for achieving them will become clear with reference to the embodiments described in detail below together with the drawings. However, the present invention is not limited to the embodiments disclosed below and may be implemented in various forms.

In the embodiments below, the terms "first," "second," etc. are not used in a limiting sense but are used to distinguish one component from another.

In the embodiments below, an expression used in the singular encompasses the expression of the plural unless it has a clearly different meaning in the context.

In the embodiments below, the terms such as "including" and "having" are intended to indicate the existence of features or components disclosed in the specification and are not intended to preclude the possibility that one or more other features or components may be added.

In the embodiments below, when it is said that a part, such as a film, region, or component, is located above or on another part, this includes not only the case where it is directly above the other part but also the case where another film, region, or component is interposed in between.

In the drawings, the sizes of components may be exaggerated or reduced for convenience of description. For example, the sizes and thicknesses of each component in the drawings are arbitrarily illustrated for convenience of description, and therefore, the present invention is not necessarily limited to the drawings.

Hereinafter, embodiments of the present disclosure will be described in detail with reference to the accompanying drawings. In the drawings, identical or corresponding components are given the same reference numerals.

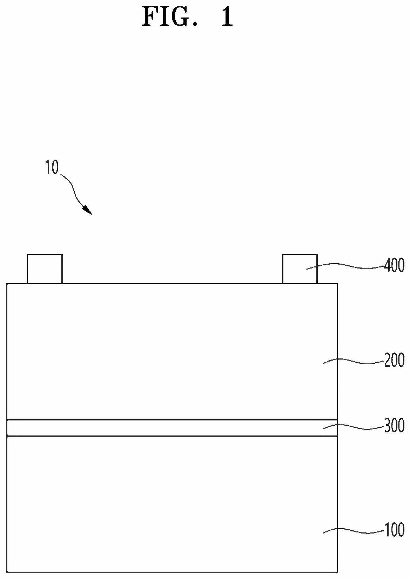

FIG. 1 is a cross-sectional view schematically illustrating a tandem solar cell according to an embodiment of the present invention.

Referring to FIG. 1, according to an embodiment of the present invention, a tandem solar cell 10 may include a first photoelectric conversion unit 100, a second photoelectric conversion unit 200 on the first photoelectric conversion unit 100, and an intermediate layer 300 positioned between the first photoelectric conversion unit 100 and the second photoelectric conversion unit 200.

The first photoelectric conversion unit 100 and the second photoelectric conversion unit 200 may each absorb sunlight and generate electrical energy, and the intermediate layer 300 electrically connects the first photoelectric conversion unit 100 to the second photoelectric conversion unit 200. Therefore, that is, the first photoelectric conversion unit 100 and the second photoelectric conversion unit 200 may be connected in series.

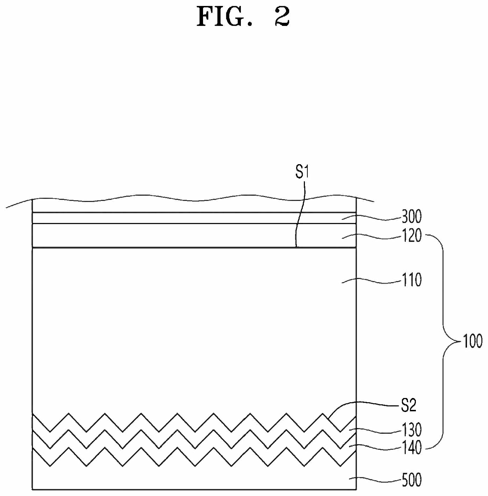

Current generated in the first photoelectric conversion unit 100 and the second photoelectric conversion unit 200 may flow to the outside of the tandem solar cell 10 through a first electrode 400 and a second electrode 500 (in FIG. 2). For example, the first electrode 400 may be positioned on a side of the second photoelectric conversion unit 200 to which sunlight is incident, and the second electrode 500 (in FIG. 2) may be positioned on the bottom surface of the first photoelectric conversion unit 100.

The first photoelectric conversion unit 100 and the second photoelectric conversion unit 200 may include photoelectric conversion layers including different materials. Therefore, since the absorption light spectra of the first photoelectric conversion unit 100 and the second photoelectric conversion unit 200 are different from each other and the magnitude of current generated from the first photoelectric conversion unit 100 may be different from the magnitude of current generated from the second photoelectric conversion unit 200, it is important to match the magnitudes of the currents respectively generated from the first photoelectric conversion unit 100 and the second photoelectric conversion unit 200, which are connected in series, in order to prevent a decrease in the efficiency of the tandem solar cell 10.

For example, the first photoelectric conversion unit 100 may correspond to a silicon solar cell, and the second photoelectric conversion unit 200 may correspond to a perovskite solar cell.

Accordingly, among light incident to the tandem solar cell 10, light in a short-wavelength range is absorbed by the perovskite solar cell in an upper portion of the tandem solar cell 10 and generates charges, and light in a long-wavelength range that passes through the perovskite solar cell is absorbed by the silicon solar cell in a lower portion of the tandem solar cell 10 and generates charges.

Accordingly, thermal loss caused by the difference between photon energy and band gap in the related art may be reduced, thereby increasing the photoconversion efficiency of the tandem solar cell 10.

The intermediate layer 300 serves to connect the first photoelectric conversion unit 100 to the second photoelectric conversion unit 200. Accordingly, the second photoelectric conversion unit 200 is electrically connected to the first photoelectric conversion unit 100 via the intermediate layer 300.

The intermediate layer 300 may be implemented using transparent conductive oxide (TCO) or a carbonaceous conductive material such that long-wavelength light passing through the second photoelectric conversion unit 200 may be incident to the first photoelectric conversion unit 100 below the intermediate layer 300 without transmission loss. The intermediate layer 300 may be doped with an n-type or p-type material.

At this time, indium tin oxide (ITO), zinc indium tin oxide (ZITO), zinc indium oxide (ZIO), zinc tin oxide (ZTO), gallium indium tin oxide (GITO), gallium indium oxide (GIO), gallium zinc oxide (GZO), aluminum doped zinc oxide (AZO), fluorine tin oxide (FTO), or ZnO may be used as the TCO. Graphene or a carbon nanotube may be used as the carbonaceous conductive material.

The intermediate layer 300 may be implemented in a multi-layer structure in which silicon layers having different refractive indices are alternately stacked multiple times. At this time, the multi-layer structure may have a structure in which low-refractive index layers and high-refractive index layers are alternately stacked. Accordingly, on the basis of the intermediate layer 300, short-wavelength light may be reflected toward the second photoelectric conversion unit 200, and long-wavelength light may be transmitted toward the first photoelectric conversion unit 100. Through this, selective light capture of the perovskite/silicon tandem solar cell 10 may be possible.

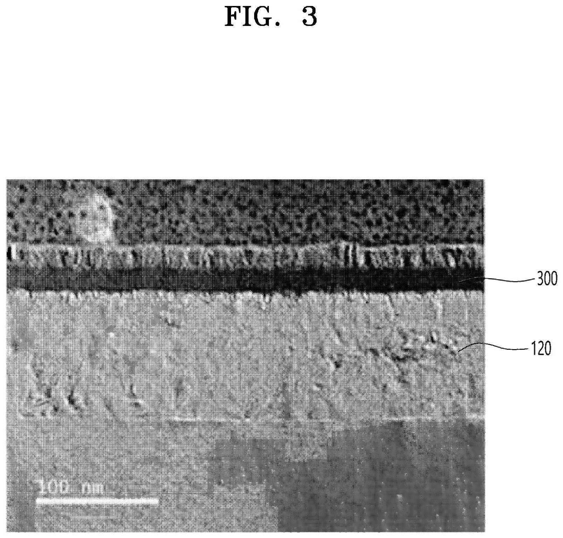

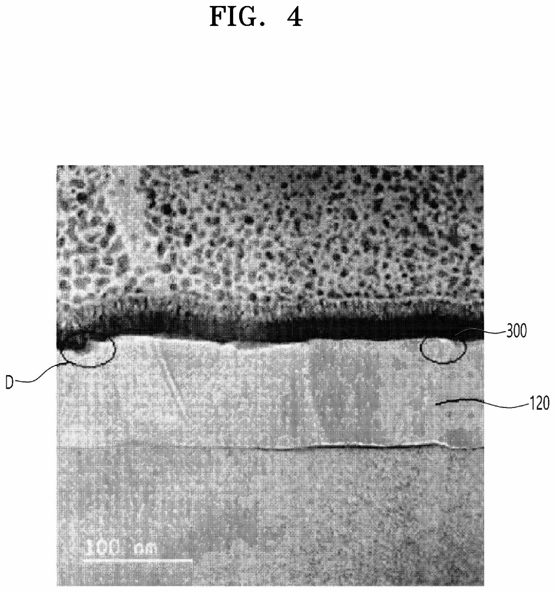

FIG. 2 is a cross-sectional view schematically illustrating an example of a first photoelectric conversion unit of the tandem solar cell of FIG. 1. FIGS. 3 and 4 are cross-sectional views each showing the results of forming an intermediate layer according to a first doped layer of the first photoelectric conversion unit of FIG. 2.

First, referring to FIG. 2, the first photoelectric conversion unit 100 may include a first photoelectric conversion layer 110, a first doped layer 120 positioned on a first surface S1 of the first photoelectric conversion layer 110 and between the first photoelectric conversion layer 110 and an intermediate layer 300, and a second doped layer 130 positioned on a second surface S2 of the first photoelectric conversion layer 110 that is opposite to the first surface S1. The first photoelectric conversion unit 100 may further include a protective layer 140 covering the second doped layer 130. The second electrode 500 may be positioned on the protective layer 140 and may penetrate the protective layer 140 so as to be electrically connected to the second doped layer 130.

The first photoelectric conversion layer 110 may include crystalline silicon. The first photoelectric conversion layer 110 may include monocrystalline silicon or polycrystalline silicon. The first photoelectric conversion layer 110 may have a first conductivity type of p-type or n-type.

The first doped layer 120 is formed through doping of a first impurity having a second conductivity type opposite to that of the first photoelectric conversion layer 110. For example, when the first photoelectric conversion layer 110 is of p-type, the first doped layer 120 is doped with an n-type impurity, and when the first photoelectric conversion layer 110 is of n-type, the first doped layer 120 is doped with a p-type impurity. As described above, when the first photoelectric conversion layer 110 and the first doped layer 120 respectively have opposite conductivity types, a PN junction is formed at the interface between the first photoelectric conversion layer 110 and the first doped layer 120. The first doped layer 120 may be formed to be hydrogen passivated to prevent recombination of carriers.

The first doped layer 120 may be formed by forming an amorphous silicon layer doped with a first impurity on the first surface S1 of the first photoelectric conversion layer 110 and then partially crystallizing the amorphous silicon layer.

For example, the amorphous silicon layer may be deposited by performing chemical vapor deposition (CVD), such as low-pressure CVD (LPCVD) or plasma-enhanced CVD (PECVD), after setting the gas ratio of SiH4 and PH3 to 5:1 to 5:6. Thereafter, the amorphous silicon layer may undergo crystallization, thereby forming the first doped layer 120. At this time, by partially crystallizing the first doped layer 120, the crystal grains of the first doped layer 120 may have a nano size. For example, the crystallinity of the first doped layer 120 may be 30 % to 70 %. That is, the crystallinity of the first photoelectric conversion layer 110 is different from that of the first doped layer 120.

When the crystallinity of the first doped layer 120 is less than 30 %, the conductivity of the first doped layer 120 may not be sufficient, making it difficult to function as an emitter layer or an electric field layer. When the crystallinity of the first doped layer 120 is greater than 70 %, it may be difficult to uniformly form a perovskite solar cell, which is described below, due to a defect in the grain boundary of polycrystalline silicon.

When the crystallinity of the first doped layer 120 is adjusted to 30 % to 70 %, the crystal grains of the first doped layer 120 have a particle size of several nm to several tens of nm. When the first doped layer 120 has an optical band gap of 1.2 eV to 1.8 eV, the absorption rate of light in the long-wavelength range is improved so that when it has a tandem structure with a perovskite solar cell, current matching with the perovskite solar cell may be optimized.

The first doped layer 120 may have a thickness of 40 nm to 100 nm. When the thickness of the first doped layer 120 is less than 40 nm, the conductivity of the first doped layer 120 may not be sufficient, making it difficult to function as an emitter layer or an electric field layer. Moreover, the flatness of the top surface of the first doped layer 120 may be reduced, making it difficult for each of the layers of the perovskite solar cell formed on the first doped layer 120 to be uniformly formed to have a constant thickness. When the thickness of the first doped layer 120 is greater than 100 nm, the current density of the first photoelectric conversion unit 100 may decrease due to increased light absorption in the first doped layer 120.

In order to ensure that the first doped layer 120 is uniformly formed with a constant thickness, it is desirable that the surface roughness of the first surface S1 is less than that of the second surface S2. For example, an uneven structure formed on the first surface S1 may have a smaller size than an uneven structure formed on the second surface S2.

A tunnel layer may be further formed between the first photoelectric conversion layer 110 and the first doped layer 120. For example, the tunnel layer may include silicon nitride (SiNx), aluminum oxide (AlOx), or silicon oxynitride (SiOxNy) and may be formed by oxidation or deposition. The tunnel layer may be formed to a thickness of 3 Å to 10 Å for a tunneling effect.

FIG. 3 and FIG. 4 are cross-sectional views each showing the result of forming the intermediate layer 300 according to the first doped layer 120. According to the present invention, FIG. 3 shows a case in which the crystallinity of the first doped layer 120 is 70 %, and FIG. 4 shows a case in which the first doped layer 120 is formed of polycrystalline silicon.

As may be seen from FIGS. 3 and 4, in the case of FIG. 3, the intermediate layer 300 is uniformly formed with a constant thickness because no defects occur in the first doped layer 120, whereas in the case of FIG. 4, the intermediate layer 300 is unevenly formed on the top surface of the first doped layer 120 due to a defect D at the grain boundary of a polycrystalline silicon layer. As shown in FIG. 4, when the intermediate layer 300 and a perovskite solar cell on the intermediate layer 300 are unevenly formed, a short circuit may occur between the perovskite solar cell and the first doped layer 120, resulting in leakage current. Therefore, according to the present invention, the stability of a tandem solar cell may be improved by preventing the occurrence of such leakage current.

Referring back to FIG. 2, the second doped layer 130 may be further positioned on the second surface S2 of the first photoelectric conversion layer 110.

The second doped layer 130 has the same conductivity type as the first photoelectric conversion layer 110 and has a higher impurity concentration than the first photoelectric conversion layer 110, thereby forming a back surface field (BSF).

The second doped layer 130 may be formed by doping the first photoelectric conversion layer 110 with a second impurity having the same conductivity type as the first photoelectric conversion layer 110 through the second surface S2. Alternatively, the second doped layer 130 may be formed by forming crystalline silicon on the second surface S2 of the first photoelectric conversion layer 110 and doping the crystalline silicon with a second impurity. In an optional embodiment, a tunnel layer is further formed between the second surface S2 of the first photoelectric conversion layer 110 and the second doped layer 130 and allows a carrier to move through a tunnel effect so that electrons or holes may be selectively collected, thereby improving an open-circuit voltage.

The second surface S2 of the first photoelectric conversion layer 110 may have surface roughness that is greater than or equal to that of the first surface S1. For example, the second surface S2 may be textured to have an uneven structure, thereby having greater surface roughness than the first surface S1. The unevenness may improve the light absorption rate of the first photoelectric conversion layer 110 by inducing scattering of long-wavelength light incident to the inside of the first photoelectric conversion unit 100, thereby increasing the current density of the first photoelectric conversion unit 100.

The protective layer 140 is formed to cover the second doped layer 130. As the second surface S2 has an uneven structure, the second doped layer 130 and the protective layer 140 may also be formed with the uneven structure.

The protective layer 140 has a single-film or multi-film structure including at least one of aluminum oxide (AlOx), silicon nitride (SiNx), silicon oxide (SiOx), and silicon oxynitride (SiOxNy) and may be formed by various processes, such as atomic layer deposition (ALD) and chemical vapor deposition (CVD, PECVD, LPCVD, or atmospheric pressure CVD (APCVD)). The protective layer 140 may increase the lifespan of a carrier by reducing the recombination density of the second surface S2 of the first photoelectric conversion layer and may minimize the reflection of light incident to the back surface of the first photoelectric conversion unit 100.

The second electrode 150 may penetrate the protective layer 140 so as to be electrically connected to the second doped layer 130. The second electrode 150 may include at least one conductive material selected from the group consisting of nickel (Ni), copper (Cu), silver (Ag), aluminum (Al), tin (Sn), zinc (Zn), indium (In), titanium (Ti), gold (Au), and a combination thereof. The second electrode 150 may be formed by various methods, such as screen printing using metal paste, plating, thermal evaporation, and sputtering.

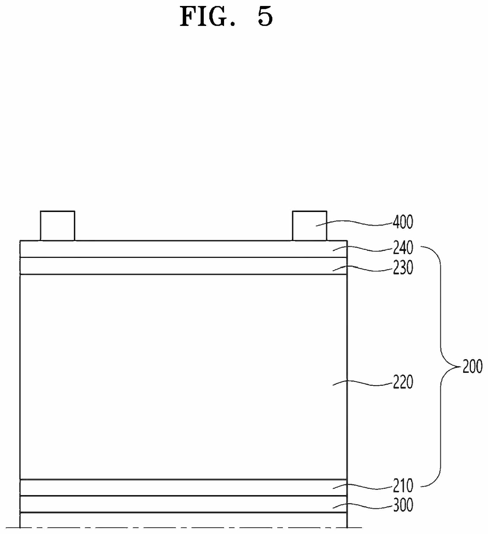

FIG. 5 is a cross-sectional view schematically illustrating an example of a second photoelectric conversion unit of the tandem solar cell of FIG. 1.

Referring to FIG. 5, the second photoelectric conversion unit 200 may include a first charge transport layer 210, a second charge transport layer 230, and a second photoelectric conversion layer 220 between the first charge transport layer 210 and the second charge transport layer 230. Additionally, the second photoelectric conversion unit 200 may further include a conductive oxide electrode layer 240 on the outer surface to which light is incident.

The first charge transport layer 210 may correspond to an electron transport layer or a hole transport layer. Specifically, when electrons move to the front and holes move to the back in a first photoelectric conversion layer so as to form electric energy, the first charge transport layer 210 may correspond to a hole transport layer. At this time, the second charge transport layer 230 may correspond to an electron transport layer.

When the first photoelectric conversion layer is configured such that holes move to the front and electrons move to the back, the first charge transport layer 210 may correspond to an electron transport layer, and the second charge transport layer 230 may correspond to a hole transport layer.

The electron transport layer may include TCO having high electrical conductivity or a carbonaceous conductive material. The TCO may include Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, In oxide, and SrTi oxide. The carbonaceous conductive materials may include graphene, a carbon nanotube, or fullerene (C60).

The hole transport layer may be formed of a conductive polymer. Specifically, the hole transport layer may include a material selected from the group consisting of Spiro-OMeTAD, PEDOT:PSS, G-PEDOT, PANI:PSS, PANI:CSA, PDBT, P3HT, PCPDTBT, PCDTBT, PTAA, 2PACz, Me-4PACz, MoO3, V2O5, NiO, WO3, CuI, CuSCN, and a combination thereof.

The second photoelectric conversion layer 220 is formed so that a hole-electron pair generated by receiving light energy from the sun may be separated into an electron or a hole. The second photoelectric conversion layer 220 is a perovskite layer and may include a compound having a perovskite structure of Chemical formula 1.

[Chemical formula 1] ABX3

In Chemical formula 1,
A is alkali metal or a substituted or unsubstituted C1-25 alkyl group,
when A is substituted, a substituent is an amino group, a hydroxyl group, a cyano group, a halogen group, a nitro group or a methoxy group;
B includes a metal cation selected from the group consisting of Pb, Sn, Ge, Cu, Ni, Co, Fe, Mn, Cr, Pd, Cd, Yb, and a combination thereof; and
X may include a halide anion or a chalcogenide anion.

More specifically, A may include formamidinium, methylammonium, cesium, rubidium, potassium, sodium, lithium guanidine, butylammonium, ethylammonium, or phenethylammonium, and B may include lead, tin, germanium, cadmium, znic, magnesium, or the like. X substances may include iodide, bromide, chloride, fluoride, thiocyanate, cyanate, selenocyanate, formate, acetate, etc.

The second photoelectric conversion layer 220 may be formed by a single-step spin-coating method, a multi-step spin-coating method, a dual-source vapor deposition method, and a vapor-assisted solution process.

The conductive oxide electrode layer 240 may be implemented with TCO having high electrical conductivity.

The first electrode 400 formed of a material with excellent electrical conductivity may be positioned on the conductive oxide electrode layer 240 and may collect charges. It is desirable that the first electrode 400 is formed using glass frit that may be fired at low temperature in order to prevent the second photoelectric conversion layer 220 from being oxidized by heat.

An anti-reflective film (not shown) may be further provided on the conductive oxide electrode layer 240. The anti-reflective film may be formed in a single or multi-film structure including at least one of magnesium fluoride (MgF2), silicon oxide (SiOx), and titanium oxide (TiOx).

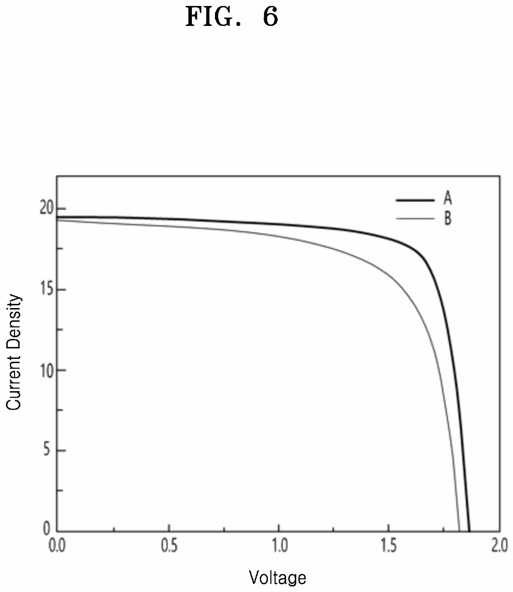

FIG. 6 is a graph showing the current-voltage (I-V) resultsof a tandem solar cell, according to the present invention.

In FIG. 6, A is an I-V result of a silicon/perovskite tandem solar cell, in which a first doped layer is partially doped and thus has a thickness of 100 nm and a crystallinity of 50 %, according to an embodiment, and B is an I-V result of a silicon/perovskite tandem solar cell, in which a first doped layer having a thickness of 100 nm is formed of polycrystalline silicon. In FIG. 6, A and B are respectively the I-V values of the tandem solar cell shown in FIG. 3 and the I-V value of the tandem solar cell shown in FIG. 4

As may be seen in FIG. 6, in the case of A, a fill factor (FF) is increased compared to B, which results from matching of a current value generated in a perovskite solar cell and a current value generated in a silicon solar cell. This is because the crystallinity of the first doped layer is 50%, and thus, the perovskite solar cell formed on the first doped layer is uniformly formed, thereby preventing leakage current generation, and simultaneously, a crystal grain of the first doped layer has a particle size of several nm to several tens of nm, and thus, the first doped layer has a wide optical band gap, thereby increasing the absorption rate of light in the long wavelength range.

Although the present invention has been described with reference to an embodiment shown in the drawings, this is merely exemplary, and one of skill in the art will understand that various modifications and variations of the embodiment can be inferred therefrom. Therefore, the technical scope of the present invention should be defined by the spirit of the appended claims.

## Claims

1. A tandem solar cell comprising:
a first photoelectric conversion unit;
a second photoelectric conversion unit on the first photoelectric conversion unit; and
an intermediate layer positioned between the first photoelectric conversion unit and the second photoelectric conversion unit and electrically connecting the first photoelectric conversion unit to the second photoelectric conversion unit,
wherein the first photoelectric conversion unit includes:
a first photoelectric conversion layer; and
a first doped layer positioned on a first surface of the first photoelectric conversion layer and between the first photoelectric conversion layer and the intermediate layer, and
surface roughness of a second surface is greater than surface roughness of the first surface.

2. The tandem solar cell of claim 1, wherein
the first photoelectric conversion unit corresponds to a silicon solar cell, and
crystallinity of the first doped layer is 30 % to 70 %.

3. The tandem solar cell of claim 1, wherein
a thickness of the first doped layer is 40 nm to 100 nm.

4. The tandem solar cell of claim 1, wherein
an optical band gap of the first doped layer is 1.2 eV to 1.8 eV.

5. The tandem solar cell of claim 1, wherein
the second surface has an uneven structure.

6. The tandem solar cell of claim 1, further comprising
a second doped layer positioned on the second surface of the first photoelectric conversion layer, the second surface being opposite to the first surface.

7. The tandem solar cell of claim 6, further comprising
a protective layer covering the second doped layer.

8. The tandem solar cell of claim 1, wherein
the second photoelectric conversion unit includes a first charge transport layer, a second charge transport layer, and a second photoelectric conversion layer between the first charge transport layer and the second charge transport layer.

9. The tandem solar cell of claim 8, wherein
the second photoelectric conversion layer includes a compound having a perovskite structure.

10. The tandem solar cell of claim 8, wherein
the second photoelectric conversion unit further includes a conductive oxide electrode layer on an outer surface thereof.

11. A tandem solar cell comprising:
a silicon solar cell;
a perovskite solar cell on the silicon solar cell; and
an intermediate layer positioned between the silicon solar cell and the perovskite solar cell and electrically connecting the silicon solar cell to the perovskite solar cell,
wherein the silicon solar cell includes a silicon semiconductor layer and a first doped layer positioned on a first surface of the silicon semiconductor layer and between the silicon semiconductor layer and the intermediate layer,
the silicon semiconductor layer and the first doped layer have different crystallinity, and
the crystallinity of the first doped layer is 30 % to 70 %.

12. The tandem solar cell of claim 11, wherein
the silicon solar cell further includes a second doped layer positioned on a second surface of the silicon semiconductor layer, the second surface being opposite to the first surface, and
surface roughness of the second surface is greater than surface roughness of the first surface.

13. The tandem solar cell of claim 12, wherein
the second surface has an uneven structure.

14. The tandem solar cell of claim 11, wherein
a thickness of the first doped layer is 40 nm to 100 nm.

15. The tandem solar cell of claim 11, wherein
an optical band gap of the first doped layer is 1.2 eV to 1.8 eV.

16. The tandem solar cell of claim 11, wherein
the perovskite solar cell includes a first charge transport layer, a second charge transport layer, and a perovskite layer between the first charge transport layer and the second charge transport layer.
